(19) Europäisches Patentamt
European Patent Office
Office européen des brevets

(11) **EP 2 403 048 A2**

(12) **EUROPEAN PATENT APPLICATION**

(43) Date of publication:
**04.01.2012 Bulletin 2012/01**

(51) Int Cl.:
**H01M 10/48** (2006.01)   **G01R 31/00** (2006.01)
**H01M 10/44** (2006.01)

(21) Application number: **11005308.9**

(22) Date of filing: **29.06.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **30.06.2010   JP 2010150566**

(71) Applicant: **Sanyo Electric Co., Ltd.
Osaka 570-8677 (JP)**

(72) Inventors:
• **Maeda, Reizo
Moriguchi-shi
Osaka 570-8677 (JP)**
• **Inui, Shinya
Moriguchi-shi
Osaka 570-8677 (JP)**
• **Tada, Makoto
Moriguchi-shi
Osaka 570-8677 (JP)**
• **Hayashida, Atsushi
Moriguchi-shi
Osaka 570-8677 (JP)**
• **Miura, Yuki
Moriguchi-shi
Osaka 570-8677 (JP)**
• **Nishida, Masayuki
Moriguchi-shi
Osaka 570-8677 (JP)**

(74) Representative: **Hertz, Oliver et al
v. Bezold & Partner
Patentanwälte
Akademiestrasse 7
80799 München (DE)**

(54) **Method of detecting battery internal resistance**

(57)     The method of detecting battery internal resistance detects battery 1 temperature and internal resistance, and computes internal resistance at each temperature. In addition to detecting battery 1 temperature, the method detects battery 1 voltage and current at each detected temperature and computes internal resistance from the measured voltages and currents. Further, internal resistance computed from actual measurements establishes battery internal resistance versus measured temperature to determine internal resistance at a plurality of battery 1 temperatures.

FIG. 7

START

DETECT BATTERY CURRENT, VOLTAGE, AND TEMPERATURE WITH A GIVEN SAMPLING PERIOD

READ INTERNAL RESISTANCE CORRESPONDING TO BATTERY TEMPERATURE FROM MEMORY

DOES THE DETECTED DATA SATISFY CONDITIONS FOR COMPUTING INTERNAL RESISTANCE?   NO

YES

COMPUTE BATTERY INTERNAL RESISTANCE

STORE THE INTERNAL RESISTANCE CORRESPONDING TO BATTERY TEMPERATURE IN MEMORY

DETERMINE THE MAXIMUM BATTERY CHARGING AND DISCHARGING CURRENT FROM BATTERY INTERNAL RESISTANCE AND TEMPERATURE, AND SEND IT TO THE VEHICLE-SIDE

END

EP 2 403 048 A2

**Description**

**BACKGROUND OF THE INVENTION**

1. Field of the Invention

The present invention relates to a method of detecting temperature-related battery internal resistance from battery temperature, voltage, and current, and in particular relates to a method of detecting battery internal resistance optimally suited for detecting internal resistance in a high output battery installed on-board a vehicle to supply power to a motor that drives the vehicle.

2. Description of the Related Art

Battery internal resistance is used as a parameter that indicates the degree of battery degradation. Accordingly, the degree of battery degradation can be determined by detecting the internal resistance of that battery. Battery lifetime can be extended by controlling the maximum allowable current according to the degree of battery degradation. This is because rapid electrical characteristic deterioration and marked battery degradation result when a degraded battery with high internal resistance is discharged at high current. When maximum battery current is limited, output is also limited and high power cannot be delivered. To achieve high power output, the maximum current needs to be increased; to prevent battery degradation, the maximum current needs to be set to a low value. Specifically, the maximum allowable discharge current is inversely related to the degree of battery degradation, and battery degradation cannot be reduced while simultaneously increasing power output. However, by properly controlling the maximum current according to the degree of battery degradation, degradation can be minimized while increasing power output. To achieve this, battery internal resistance must be accurately detected, and the degree of battery degradation must be determined from that internal resistance.

Battery internal resistance can be computed from battery voltage and current. The battery internal resistance can be computed by the following equation using the detected battery voltage with a given current flow and that given current value.

$$\text{internal resistance} = (\text{open circuit voltage} - \text{detected voltage}) / \text{current}$$

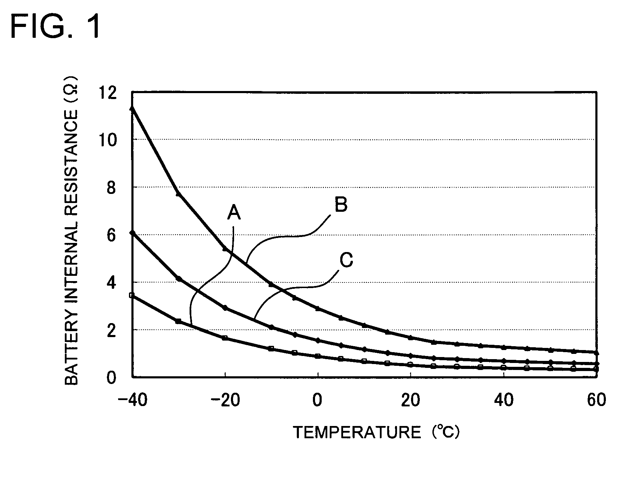

Further, by measuring many current-voltage data points, battery internal resistance can be determined more accurately. However, battery internal resistance varies with temperature. Fig. 1 shows the variation in internal resistance with battery temperature. In this figure, curve A shows early-life internal resistance, curve B shows end-of-life internal resistance, and curve C shows internal resistance for a battery in the middle of its lifetime. As shown in this figure, battery internal resistance varies with temperature as a parameter.

To correctly determine battery internal resistance, battery voltage, current, and temperature are measured, and battery internal resistance is computed for the measured temperature. However, the battery is not always used over the entire temperature range. Consequently, as shown in Fig. 1, even if battery internal resistance can be detected at normal ambient temperatures, internal resistance at temperatures such as -10°C or -20°C cannot be determined unless the battery is used at those temperatures. If the battery is discharged at a temperature where internal resistance could not be detected, a maximum current based on the internal resistance cannot be set. Therefore, the system has the drawback that a maximum current cannot be set, and the battery cannot be protected, for example, when suddenly discharged at a low temperature.

A method of estimating battery internal resistance has been developed to overcome this drawback. For instance, when internal resistance is detected at a normal ambient temperature, internal resistance at a different temperature is estimated from the internal resistance at the measured temperature.

For example, refer to Japanese Laid-Open Patent Publication 2000-12104.

In the disclosure cited above, battery internal resistance at the operating temperature and battery lifetime are estimated from the internal resistance detected at a given temperature. This method can determine battery internal resistance at unmeasured temperatures. However, since battery internal resistance at temperatures where measurements are not actually made is estimated from internal resistance at a given temperature, this system has the drawback that the battery internal resistance cannot be accurately determined over a wide temperature range.

The present invention was developed to further resolve the drawbacks described above. Thus, it is a primary object of the present invention to provide a method of detecting battery internal resistance that can more accurately determine battery internal resistance over a wide temperature range.

## SUMMARY OF THE INVENTION

The method of detecting battery internal resistance of the present invention detects battery 1 temperature and internal resistance, and computes internal resistance at each temperature. In addition to detecting battery 1 temperature, the method detects battery 1 voltage and current at each detected temperature and computes internal resistance from the measured voltages and currents. Further, internal resistance computed from actual measurements establishes battery internal resistance versus measured temperature to detect internal resistance at a plurality of battery 1 temperatures.

The method of detecting battery internal resistance described above does not estimate battery internal resistance at other temperatures based on the internal resistance detected at a given temperature. Rather, the method uses actual measured battery internal resistance at a plurality of temperatures to detect internal resistance at a plurality of temperatures. Consequently, the method has the characteristic that battery internal resistance can be detected more accurately over a wide range of temperatures.

The method of detecting battery internal resistance of the present invention can store in memory 11 actual measured internal resistance and relation between the internal resistance and the degree of degradation data indicating the degree of battery degradation corresponding to the internal resistance within a given temperature range. Further, the degree of battery degradation can be determined from the internal resistance actually measured at a specific temperature using the relation between the internal resistance and the degree of degradation data stored in memory 11. This method of detecting internal resistance has the characteristic that the degree of battery degradation can be accurately determined for battery operation over a wide range of temperatures.

The method of detecting battery internal resistance of the present invention can set the maximum current for battery charging and discharging from battery temperature, detected internal resistance, and battery voltage. With this detection method, the battery can be discharged with a large allowable current while minimizing battery degradation.

The method of detecting battery internal resistance of the present invention can detect battery voltage and current with a given sampling rate, and can compute battery internal resistance from a plurality of current and voltage measurements made over a preset measurement time interval. Further, battery internal resistance can be computed using data detected during the measurement time interval that includes battery current, which is higher than a predetermined current setting. This detection method can compute battery internal resistance more accurately because in addition to computing internal resistance from a plurality of detection points, it detects internal resistance in a high current region, where it can be detected more accurately.

The method of detecting battery internal resistance of the present invention can set the predetermined current during discharging proportional to (open circuit battery voltage - the battery low voltage limit) and inversely proportional to battery internal resistance. Further, the method can set the predetermined current during charging proportional to (the battery high voltage limit - open circuit battery voltage) and inversely proportional to battery internal resistance.
Here, open circuit battery voltage is the battery voltage with no current
flow, the battery low voltage limit is the lowest allowable battery voltage,
and the battery high voltage limit is the highest allowable battery voltage. Since this detection method sets the current for detecting battery internal resistance in a range higher than a specific current, it can detect internal resistance more accurately.

The method of detecting battery internal resistance of the present invention can detect battery voltage and current with a given sampling rate, and can compute battery internal resistance from a plurality of current and voltage measurements made over a preset measurement time interval. Further, battery internal resistance can be computed using data detected during the measurement time interval that includes battery voltage, which is within a predetermined voltage range, and the battery voltage range setting is characterized by the battery temperature. This detection method can compute battery internal resistance more accurately because the voltage range is set to a voltage region where battery internal resistance can be accurately detected.

The method of detecting battery internal resistance of the present invention can set the predetermined voltage range between the battery high voltage limit and the high voltage limit minus 10% to 50% of (the battery high voltage limit - the battery low voltage limit) and between the battery low voltage limit and the low voltage limit plus 10% to 50% of (the battery high voltage limit - the battery low voltage limit). This detection method can compute battery internal resistance more accurately by specifying a set voltage range.

The method of detecting battery internal resistance of the present invention can set the maximum current for battery charging and discharging from battery temperature, detected internal resistance, and battery voltage. Further, when battery internal resistance has not been computed at the present temperature for a given time period and a previously detected (old) battery internal resistance for that temperature is stored in memory 11, battery internal resistance detected more recently than the old internal resistance, but at a temperature different than the present temperature, can be used to estimate the internal resistance at the present temperature from a pre-stored look-up-table or function. Further, the maximum battery current can be set based on either the old internal resistance or the estimated internal resistance.

This detection method can protect the battery during discharging even when internal resistance has not been detected for a long time period at the current battery temperature.

The method of detecting battery internal resistance of the present invention can set the maximum current for battery charging and discharging from battery temperature, detected internal resistance, and battery voltage. Further, when battery internal resistance has not been computed at the present temperature for a given time period and a previously detected (old) battery internal resistance for that temperature is stored in memory 11, battery internal resistance detected more recently than the old internal resistance, but at a temperature different than the present temperature, can be used to estimate the internal resistance at the present temperature from a pre-stored look-up-table or function. Further, when the difference between the estimated internal resistance and the old internal resistance is greater than a specified difference, the maximum battery current can be set based on the estimated internal resistance. This detection method can protect the battery during discharging even when internal resistance has not been detected for a long time period at the current battery temperature. In particular, even when battery temperature becomes a value where internal resistance has not been detected for an exceptionally long time, the battery can be discharged with high current while preventing battery degradation.

The battery, in which internal resistance is determined by the method of detecting battery internal resistance of the present invention, can be a battery installed on-board a vehicle to supply power to a motor that drives the vehicle. This detection method has the characteristic that power can be supplied to a motor that drives a vehicle while protecting the battery over a wide temperature range and discharging the battery with a maximum current that minimizes battery degradation. The above and further objects of the present invention as well as the features thereof will become more apparent from the following detailed description to be made in conjunction with the accompanying drawings.

## BRIEF DESCRIPTION OF THE DRAWINGS

Fig. 1 is a graph showing battery internal resistance as a function of battery temperature;
Fig. 2 is a block diagram of a power source apparatus using a method of detecting battery internal resistance for an embodiment of the present invention;
Fig. 3 is an equivalent circuit diagram of a battery with internal resistance;
Fig. 4 is a graph showing current-voltage characteristics during battery charging and discharging;
Fig. 5 is a graph showing the distribution of a plurality of current-voltage data-points taken during a measurement time interval;
Fig. 6 is a graph showing battery internal resistance estimated from recently acquired internal resistance and (old) internal resistance previously stored in memory;
Fig. 7 is a flowchart showing battery internal resistance computation by the decision circuit;
Fig. 8 is a flowchart showing decision circuit estimation of an internal resistance that is more accurate than an old internal resistance; and
Fig. 9 is a block diagram showing an example of a power source apparatus used in a power storage application.

## DETAILED DESCRIPTION OF THE EMBODIMENT(S)

The following describes embodiments of the present invention based on the figures.

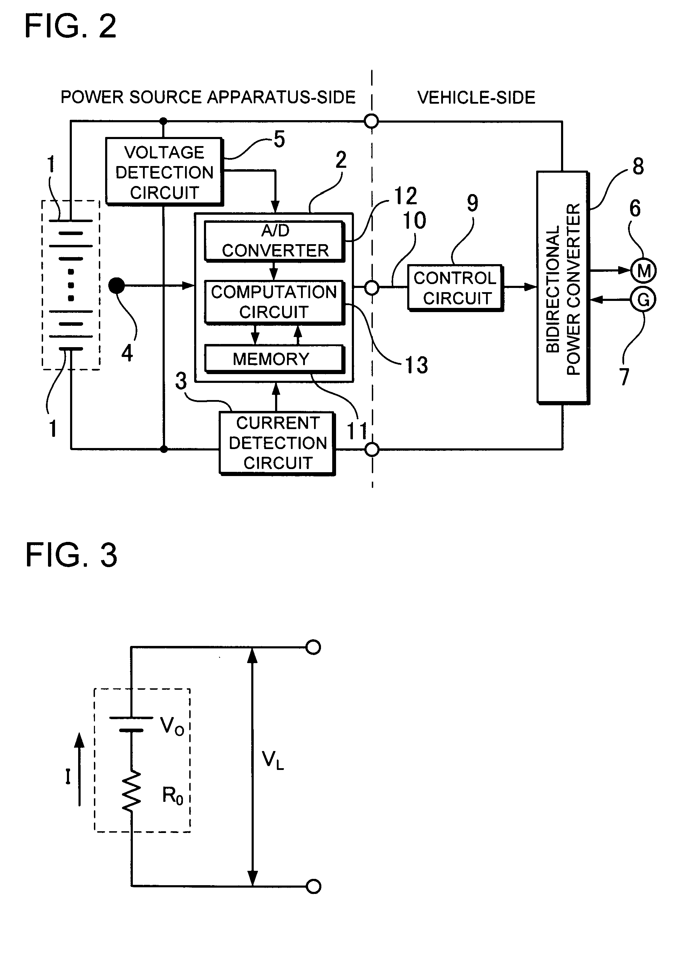

Fig. 2 is a block diagram of a power source apparatus that uses the method of detecting battery internal resistance of the present invention. The figure shows a block diagram for detecting internal resistance in a battery 1 installed in a hybrid vehicle. The battery 1 is discharged to supply power to the vehicle driving motor 6, and is charged by a generator 7. The internal resistance of the battery 1 is determined by a decision circuit 2. To determine battery internal resistance, the decision circuit 2 connects to a current detection circuit 3 that detects charging and discharging current flowing through the battery 1, a temperature sensor 4 that detects battery 1 temperature, and a voltage detection circuit 5 that detects battery 1 voltage.

A bidirectional power converter 8 is provided on the vehicle-side to supply power from the battery 1 to the motor 6, and from the generator 7 to the battery 1. The bidirectional power converter 8 converts direct current (DC) from the battery 1 to three-phase alternating current (AC) for the motor 6, and converts AC output from the generator 7 to DC for the battery 1. The bidirectional power converter 8 is controlled by a control circuit 9 that controls supply current from the battery 1 to the motor 6, and charging current from the generator 7 to the battery 1. The control circuit 9 controls the bidirectional power converter 8 to control battery 1 current according to battery 1 data signals sent via communication lines 10 from the decision circuit 2 on the power source apparatus-side.

The decision circuit 2 detects battery internal resistance, determines the degree of battery degradation from the detected internal resistance, sets the maximum current for battery 1 charging and discharging from the degree of degradation, and sends battery data signals to the control circuit 9 on the vehicle-side. The control circuit 9 controls the bidirectional power converter 8 based on the information sent from the battery-side. The control circuit 9 controls the bidirectional power converter 8 to keep battery 1 charging and discharging current from exceeding the maximum current value sent from the battery-side. With this manner of control circuit 9 administration over motor 6 and generator 7 output through the bidirectional power converter 8, battery 1 charging and discharging current can be increased while minimizing battery 1 degradation. This enables the battery 1 to achieve a lifetime close to its target value.

The decision circuit 2 contains memory 11, and the battery internal resistance is stored in memory 11 for each temperature. The decision circuit 2 determines the degree of battery degradation from internal resistance, determines the maximum current from the degree of degradation, and transmits that information to the vehicle-side control circuit 9 via the communication lines 10. The decision circuit 2 computes internal resistance from battery 1 temperature, charging and discharging current, and battery voltage. The decision circuit 2 computes battery internal resistance from the equation given below.

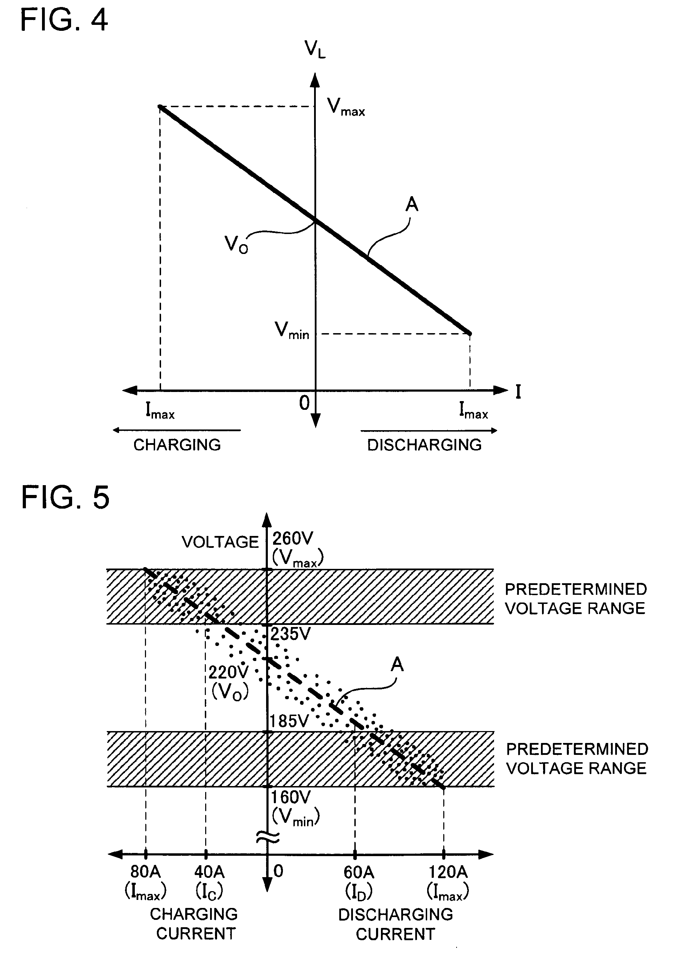

An equivalent circuit of a battery 1 with internal resistance is shown in Fig. 3. If the battery 1 in this equivalent circuit is charged and discharged and current (I) and output voltage (VL) are measured, the current-voltage characteristics can be plotted as shown in Fig. 4. In Fig. 4, the battery 1 internal resistance (R0) can be computed from the slope of the linear current-voltage characteristics (line A). Here, if Vo is the battery 1 open circuit voltage, and VL is the voltage at a current (I),

$$VL = Vo - R0 \times I$$

and from that equation, internal resistance can be computed.

$$R0 = (Vo - VL) / I$$

In the method described above, battery internal resistance can be computed more accurately using many current and voltage data points. To implement this, the decision circuit 2 detects many current and voltage data points at a given sampling rate, and computes battery internal resistance more accurately from detection data that includes a plurality of current and voltage points. Further, battery internal resistance varies with temperature. Accordingly, the decision circuit 2 detects battery 1 temperature together with current and voltage to compute internal resistance corresponding to the detected temperature. Ideally, current and voltage are detected together in a synchronous manner. However, current and voltage can also be detected asynchronously if negligible error results by computing internal resistance with a delay between the current and voltage measurements. Specifically, current and voltage can also be detected with a slight time delay between measurements such as $\leq$ 100msec between measurements.

The decision circuit 2 is provided with an A/D converter 12 that detects battery 1 temperature, current, and voltage with a given sampling rate and converts those values to digital signals, a computation circuit 13 that computes battery internal resistance from detected data output from the A/D converter 12, and memory 11 that stores the battery internal resistance computed by the computation circuit 13.

To determine battery internal resistance more accurately, the decision circuit 2 A/D converter 12 converts battery 1 temperature, current, and voltage to digital signals at a given sampling rate. Those digital signals are input to the computation circuit 13. The computation circuit 13 computes battery internal resistance from the input measured data, which includes battery 1 current and voltage. In addition, the degree of battery degradation is determined from the computed internal resistance, and the maximum current for battery 1 charging and discharging is determined from the degree of degradation.

For example, the A/D converter 12 converts temperature, current, and voltage to digital signals with a 100msec sampling period and outputs those signals to computation circuit 13. However, the A/D converter 12 sampling period can also be from 30msec to 500msec. Shortening the A/D converter 12 sampling period allows battery internal resistance to be determined more accurately. However, shortening the A/D converter sampling period requires the use of a high processing speed converter and computation circuit, and increases component cost. A/D converter and computation circuit cost can be reduced by reducing the sampling speed and using low-cost components. However, accurate battery internal resistance determination becomes more difficult as the sampling speed is reduced. Therefore, the A/D converter sampling period is set to an optimum value considering component cost and detection accuracy.

The computation circuit 13 computes battery internal resistance from data that includes a plurality of current and voltage points detected over a preset measurement time interval such as 10sec. If the sampling period is 100msec and the measurement time interval is 10sec, one hundred current and voltage data points are acquired during the measurement time interval. The plurality of current and voltage data points detected during a measurement time interval are distributed, for example, as shown in Fig. 5. From this distribution, the computation circuit 13 computes internal resistance from the slope of a line (A) that represents the current-voltage characteristics according to a statistical regression such as the method of least squares.

If battery 1 temperature varies during the 10sec measurement time interval, the internal resistance cannot be determined for one detected temperature. Accordingly, if battery 1 temperature varies during the measurement time interval, the decision circuit 2 suspends battery internal resistance computation using that detected data and instead computes battery internal resistance from the next measurement data to be input. The amount of battery 1 temperature variation requiring suspension of internal resistance computation is pre-loaded in memory 11. For example, if battery 1 temperature variation during the measurement time interval is less than or equal to 0.5°C to 3°C, battery 1 temperature variation can be assumed negligible and battery internal resistance is computed. If battery 1 temperature varies more than 0.5°C to 3°C during the measurement time interval, battery 1 temperature variation is assumed and internal resistance is not computed from the detected data.

If the measurement time interval for battery internal resistance computation is lengthened, the decision circuit 2 can compute a more accurate internal resistance from more data points. However, if the measurement time interval is lengthened, battery temperature variation during that time interval becomes more likely and the possibility of computing internal resistance at a given temperature becomes less likely. Battery temperature variation during the measurement time interval can be reduced by shortening the measurement time interval. However, if the measurement time interval is shortened, the number of current and voltage data points detected for computing battery internal resistance is reduced, and accurate internal resistance computation becomes difficult. From these considerations, the measurement time interval for computing battery internal resistance is set to a time interval, such as 1 sec to 60sec, where there is little battery temperature variation and where the battery internal resistance can be accurately determined.

Battery internal resistance can be computed with greater accuracy at higher charging and discharging currents. Accordingly, the computation circuit 13 computes battery internal resistance in a measurement time interval only from data that includes detected battery 1 current higher than a predetermined current setting. For example, the computation circuit can compute battery internal resistance from data detected in a measurement time interval when the number of current measurements higher than the predetermined current setting is greater than a given percentage of the plurality of current values measured during that time interval.

The predetermined current during discharging can be set proportional to (open circuit battery voltage - the battery low voltage limit) and inversely proportional to battery internal resistance. Further, the predetermined current during charging can be set proportional to (the battery high voltage limit - open circuit battery voltage) and inversely proportional to battery internal resistance. Here, open circuit battery voltage is the battery voltage with no current flow, the battery low voltage limit is the lowest allowable battery voltage, and the battery high voltage limit is the highest allowable battery voltage.

For example in Fig. 5, the predetermined discharging current ($I_D$) for computing battery internal resistance (R0) during discharging is set proportional to (Vo - Vmin) and inversely proportional to the battery internal resistance (R0). The battery internal resistance (R0) used to set the predetermined current ($I_D$) is the internal resistance at the most recent battery temperature, or is the internal resistance estimated for the present temperature from the internal resistance at a given temperature.

Here, Vo is the open circuit voltage, and

Vmin is the battery low voltage limit.

For example, the predetermined discharging current ($I_D$) is set by the formula

$$I_D = 0.5 \times (Vo - Vmin) / R0.$$

Here, if

$$Vo = 220V, Vmin = 160V, and R0 = 0.5\Omega,$$

the predetermined discharging current ($I_D$) setting is 60A. With the predetermined discharging current ($I_D$) set to 60A, battery internal resistance is determined from measurement data that includes discharging current values greater than 60A. Conversely, battery internal resistance is not computed from measurement data when none of the plurality of discharging current values exceed 60A.

Further in Fig. 5, the predetermined charging current ($I_C$) for computing battery internal resistance (R0) during charging is set proportional to (Vmax - Vo) and inversely proportional to the battery internal resistance (R0). The battery internal resistance (R0) used to set the predetermined current ($I_C$) is the internal resistance at the most recent battery temperature, or is the internal resistance estimated for the present temperature from the internal resistance at a given temperature.

Here, Vo is the open circuit voltage, and

Vmax is the battery high voltage limit.

For example, the predetermined charging current ($I_C$) is set by the formula

$$I_C = 0.5 \times (Vmax - Vo) / R0.$$

Here, if

$$Vo = 220V, \ Vmax = 260V, \ and \ R0 = 0.5\Omega,$$

the predetermined charging current ($I_C$) setting is 40A. With the predetermined charging current ($I_C$) set to 40A, battery internal resistance is determined from measurement data that includes charging current values greater than 40A. Conversely, battery internal resistance is not computed from measurement data when none of the plurality of charging current values exceed 40A.

Since the battery can have a plurality of battery cells connected in parallel to increase current, the predetermined current setting for a battery with battery cells connected in parallel is the battery cell predetermined current multiplied by the number of parallel-connected battery cells.

In a similar manner, battery internal resistance can be accurately detected considering voltage measurements included in the detected data. This method computes battery internal resistance using data detected during the measurement time interval that includes battery voltage, which is within a predetermined voltage range

The predetermined voltage range is set to the region between Vmax and Vmax minus 25% of (Vmax - Vmin) and to the region between Vmin and Vmin plus 25% of (Vmax - Vmin). However, the size of the predetermined voltage range regions can also be set from 10% to 50% of (Vmax - Vmin). Here, Vmax is the battery high voltage limit, and Vmin is the battery low voltage limit.

If Vmax is 260V, Vmin is 160V, and the size of the predetermined voltage range regions is 25% of (Vmax - Vmin), the predetermined voltage range becomes the regions from 235V to 260V and from 160V to 185V. These predetermined voltage range regions are shown by the cross-hatched regions in Fig. 5. In this figure, battery internal resistance is computed only from detected data having at least one voltage within a cross-hatched region. For example, the computation circuit can compute battery internal resistance from data detected in a measurement time interval when the number of voltage measurements within the predetermined voltage range is greater than a given percentage of the plurality of voltages measured during that time interval. When none of the voltage values included in a measured data set fall within a cross-hatched region, battery internal resistance is not computed from that data.

Further, when the operating environment and battery 1 temperature changes and the temperature becomes a value where the battery 1 has not been used for an extended time period, the detected internal resistance stored in memory 11 for that temperature is a notably old value. For example, when battery 1 temperature becomes -20°C, where the battery 1 has not been used for several years, the battery internal resistance detected several years ago at -20°C is stored in memory 11 for that temperature. However, there is a good chance the present internal resistance at -20°C has changed from the value stored in memory 11. Even in this situation, a maximum current must be set for the battery 1. Specifically, before detecting the battery internal resistance at -20°C, it is necessary to set the maximum battery current and output that value to the vehicle-side. This is because the battery must be charged or discharged before the battery internal resistance can be detected.

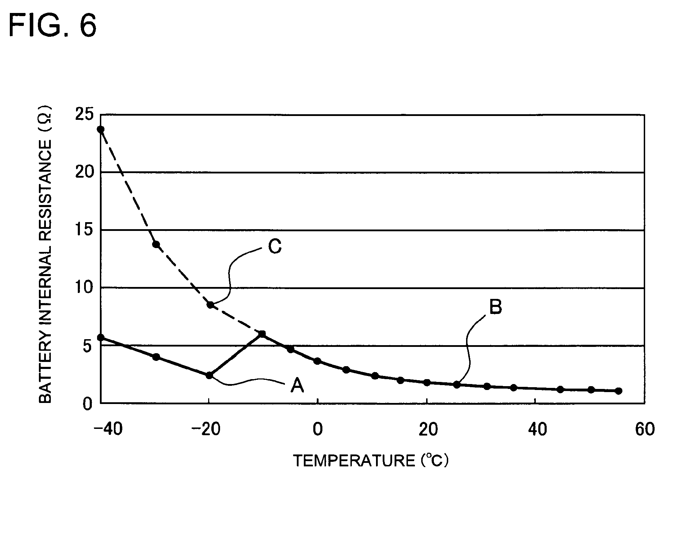

This situation is illustrated in Fig. 6. In this figure, point A is the old internal resistance stored in memory 11 that was previously detected at -20°C. Point B is a new internal resistance value recently detected at 25°C prior to the temperature drop to -20°C. Because battery internal resistance varies with temperature, the decision circuit 2 can estimate battery internal resistance at the present temperature (-20°C) from the recently detected new internal resistance using a per-stored look-up-table or function. Point C is the battery internal resistance at -20°C estimated from the new internal resistance using a look-up-table or function. Here, the internal resistance at point C is a value estimated from a different temperature, the internal resistance at point A is the old measured value, and neither value represents an accurate up-to-date internal resistance. However, if the old internal resistance was measured considerably in the past, the probability is high that it is significantly different than the present internal resistance. Consequently, the estimated internal resistance at point C can be assumed more accurate than the old internal resistance.

Accordingly, the internal resistance estimated from the new internal resistance is compared to the old internal resistance. When the difference between the two values is greater than a set difference, the estimated internal resistance is assumed to be more accurate, and the maximum battery current is set based on the estimated internal resistance. When the battery is charged or discharged with the maximum current set in this manner, battery internal resistance is accurately detected from the associated current and voltage.

In the method described above, internal resistance at the battery operating temperature is determined and stored in memory 11. At that time, the old internal resistance stored in memory 11 can be over-written by the actual measured internal resistance. However, a more accurate internal resistance can result by over-writing memory with an internal resistance computed in the following manner.

$$\text{internal resistance written to memory} = \text{weight1} \times \text{old internal}$$

$$\text{resistance} + \text{weight2} \times \text{actual measured internal resistance}$$

Here, weight1 + weight2 = 1, the proportion of the actual measured internal resistance can be increased by increasing weight2, and the proportion of the old internal resistance can be increased by increasing weight1. Preferably, weight2 is set from 0.1 to 0.5. It should be noted that the old internal resistance is a value repeatedly updated with actual measurements gradually increasing its accuracy over time.

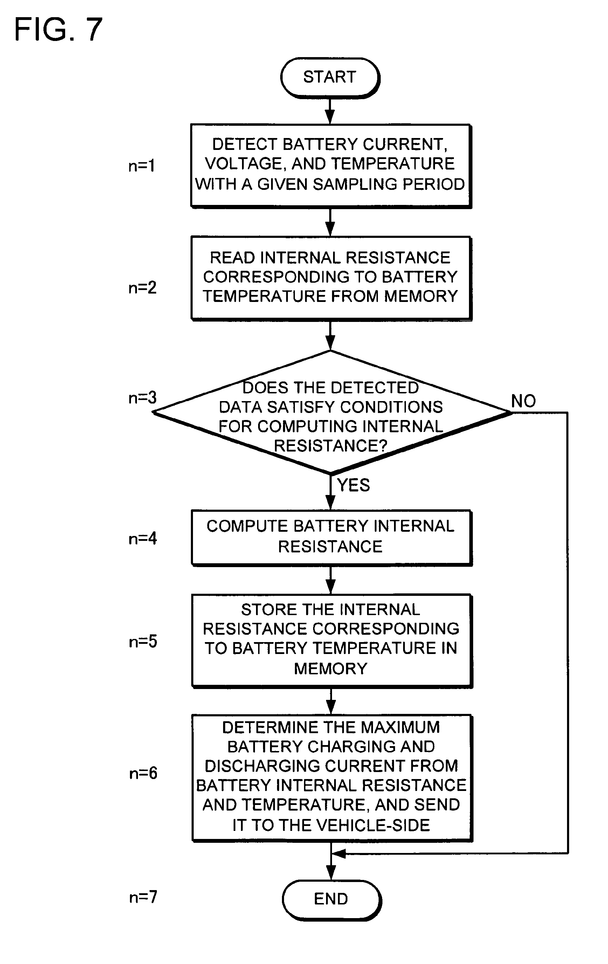

The decision circuit 2 described above computes battery internal resistance according to the flowchart of Fig. 7 (described below).

[step 1]

This step detects battery 1 current, voltage, and temperature. In this step, current, voltage, and temperature are detected a plurality of times with a given periodicity. For example, data is collected for 10sec with a 100msec sampling period. Specifically, current, voltage, and temperature are detected one hundred times to establish the measurement data for internal resistance computation.

[step 2]

This step reads internal resistance corresponding to the battery 1 temperature from memory 11.

[step 3]

This step determines whether or not the detected data satisfies the conditions for computing internal resistance. For example, it determines if the measured data includes any voltages within the predetermined voltage range, and it determines if the measured data includes any currents within the predetermined current range. In addition, this step determines conditions such as whether battery 1 temperature changed during measurement. If the detected data does not satisfy the conditions for computing internal resistance, control jumps to step 7.

[step 4]

If the detected data satisfies the conditions for computing internal resistance, the computation circuit 13 computes battery internal resistance from the detected data in this step.

[step 5]

This step stores the computed battery internal resistance, or the battery internal resistance computed from an old internal resistance stored in memory 11 and the actual measured internal resistance, as the internal resistance corresponding to battery 1 temperature in memory 11.

[step 6]

This step sets the maximum battery current for charging and discharging from the battery internal resistance and temperature and sends it to the vehicle-side. To set the maximum battery current from the internal resistance and temperature, a look-up-table or function relating maximum current to internal resistance and temperature is pre-loaded in memory 11. The look-up-table or function stored in memory 11 sets the maximum current lower for higher internal resistance and sets the maximum current lower when battery 1 temperature becomes higher or lower.

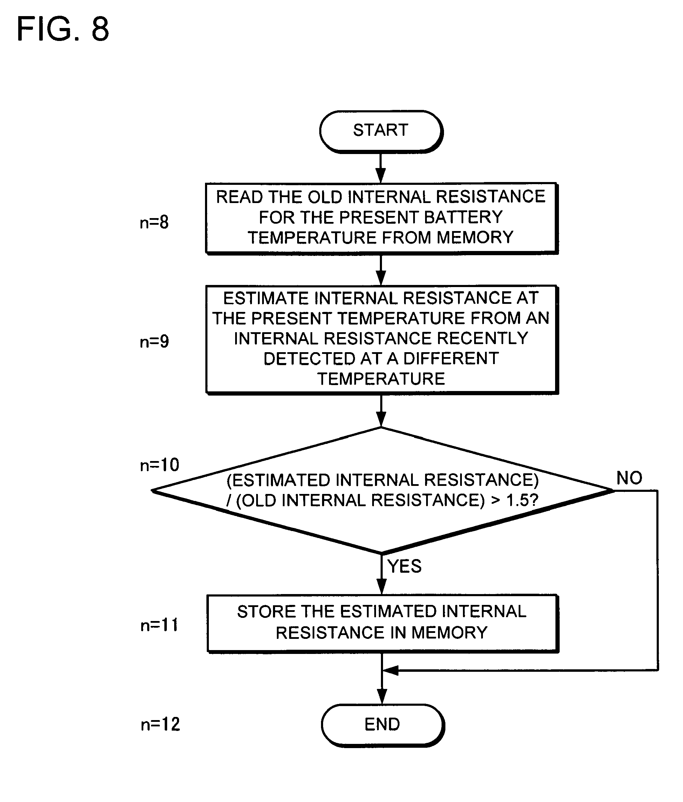

[0054]  [0048] The decision circuit 2 can estimate an internal resistance more accurate than an old internal resistance according to the flowchart shown in Fig. 8 and described below.

[step 8]

This step reads the old internal resistance for the present battery 1 temperature (for example, -20°C) from memory 11.

[step 9]

This step determines an estimated internal resistance at the present temperature (-20°C) from an internal resistance recently detected at a temperature (for example, 25°C) different than the present temperature. To make this estimation, the decision circuit 2 has a look-up-table or function relating internal resistance to temperature stored in memory 11.

[steps 10-12]

Step 10 compares the estimated internal resistance determined from internal resistance at a temperature different than the present temperature with the old internal resistance at the present temperature stored in memory 11, and judges whether or not the estimated internal resistance is more than 1.5 times the old internal resistance. If the estimated internal resistance is more than 1.5 times the old internal resistance, the old internal resistance is assumed to be considerably old and significantly different from the actual internal resistance at the present temperature. Accordingly, the estimated internal resistance is stored in memory 11 as the internal resistance at the present temperature (step 11). If the ratio of the estimated internal resistance to the old internal resistance is not greater than 1.5, the old internal resistance in memory 11 is not over-written and is used as the internal resistance at the present temperature.
In the manner described above, the decision circuit over-writes the old internal resistance stored in memory 11 with the estimated internal resistance, or uses the old internal resistance as the internal resistance at the present temperature without changing the contents of memory 11.
The degree of battery degradation is continuously determined from the battery internal resistance stored in memory 11. Relation between the internal resistance and the degree of degradation data indicating the degree of battery degradation corresponding to the internal resistance is stored in memory 11 for a given temperature range. Based on the relation between the internal resistance and the degree of degradation data in memory 11, the decision circuit 2 determines the degree of battery degradation from the internal resistance actually measured at a specific temperature. Further, the decision circuit 2 determines the maximum current for battery 1 charging and discharging from the degree of battery degradation, and sends that data to the vehicle-side. When required, the degree of battery degradation is also sent to the vehicle-side. On the vehicle-side, the control circuit 9 controls the bidirectional power converter 8 according to the received maximum current and degree of degradation data to control battery 1 charging and discharging.

(Power Source Apparatus in a Power Storage Application)

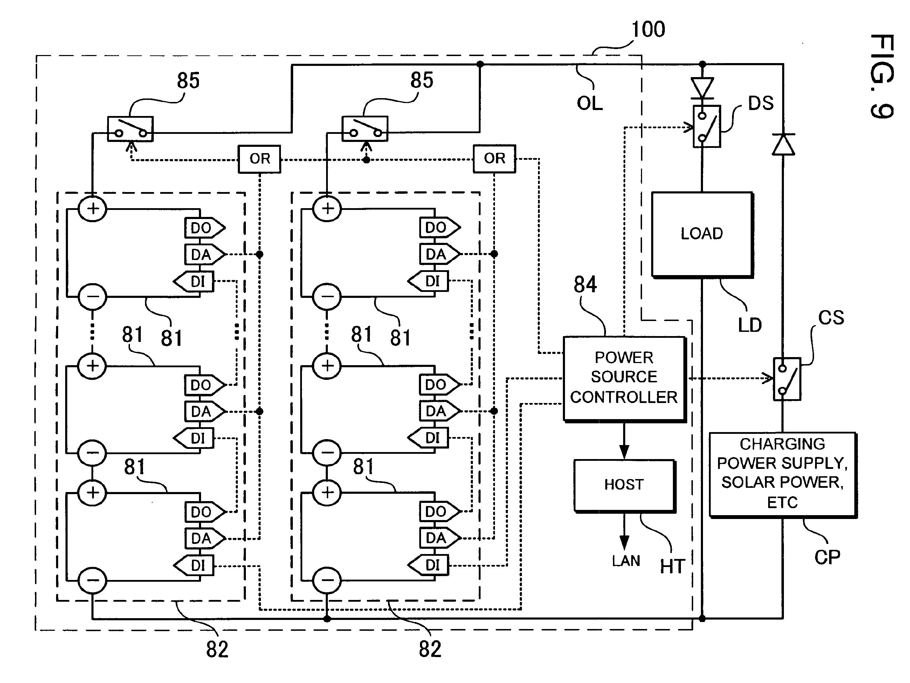

Fig. 9 shows a power source apparatus used as a mobile power storage resource. For example, it can be used as a power source system in the home or manufacturing facility that is charged by solar power or late-night (reduced-rate) power and discharged as required. It can also be used for applications such as a streetlight power source that is charged during the day by solar power and discharged at night, or as a backup power source to operate traffic signals during power outage. After charging batteries 82 with a charging power supply CP, the power source apparatus 100 shown in Fig. 9 drives a load LD. Accordingly, the power source apparatus 100 has a charging mode and a discharging mode. The load LD and the charging power supply CP are connected to the power source apparatus 100 through a discharge switch DS and a charging switch CS respectively. The discharge switch DS and the charging switch CS are controlled ON and OFF by a power source apparatus 100 power source controller 84. In the charging mode, the power source controller 84 switches the charging switch CS ON and the discharge switch DS OFF to allow the power source apparatus 100 to be charged from the charging power supply CP. When charging is completed by fully-charging the batteries or by charging to a battery capacity at or above a given capacity, the power source apparatus can be switched to the discharging mode depending on demand by the load LD. In the discharging mode, the power source controller 84 switches the charging switch CS OFF and the discharge switch DS ON to allow discharge from the power source apparatus 100 to the load LD. Further, depending on requirements, both the charging switch CS and the discharge switch DS can be turned ON to allow power to be simultaneously supplied to the load LD while charging the power source apparatus 100.
The load LD driven by the power source apparatus 100 is connected through the discharge switch DS. In the discharging mode, the power source controller 84 switches the discharge switch DS ON to connect and drive the load LD with power from the power source apparatus 100. A switching device such as a field effect transistor (FET) can be used as the discharge switch DS. The discharge switch DS is controlled ON and OFF by the power source apparatus 100 power source controller 84. In addition, the power source controller 84 is provided with a communication interface to communicate with externally connected equipment. In the example of Fig. 9, the power source controller 84 is connected to an external host computer HT and communicates via known protocols such as universal asynchronous receiver transmitter (UART) and recommended standard-232 (RS-232C) protocols. Further, depending on requirements, a user interface can also be provided to allow direct user operation. Each battery pack 81 in the power source apparatus is provided with signal terminals and power terminals. The signal terminals include a battery pack input-output terminal DI, a battery pack error output terminal DA, and a battery pack connecting terminal DO. The battery pack input-output terminal DI allows output and input of signals to and from the power source controller 84 and other battery packs. The battery pack connecting terminal DO allows output and input of signals to and from another related battery pack. The battery pack error output terminal DA serves to output battery pack abnormalities to components and devices outside the battery pack. In addition, the power terminals allow the battery packs 81 to be connected in series or parallel. Battery units 82 are connected in parallel to the output line OL via parallel connecting switches 85.

It should be apparent to those with an ordinary skill in the art that while various preferred embodiments of the invention have been shown and described, it is contemplated that the invention is not limited to the particular embodiments disclosed, which are deemed to be merely illustrative of the inventive concepts and should not be interpreted as limiting the scope of the invention, and which are suitable for all modifications and changes falling within the spirit and scope of the invention as defined in the appended claims.

**Claims**

1. A method of detecting battery internal resistance that detects battery temperature and internal resistance, and computes internal resistance at each temperature, the method comprising:

   detecting battery temperature, and detect battery voltage and current at each detected temperature;
   computing internal resistance from the measured voltages and currents; and
   establishing battery internal resistance versus measured temperature using the internal resistance computed from actual measurements to determine internal resistance at a plurality of battery temperatures.

2. The method of detecting battery internal resistance as cited in claim 1 wherein actual measured internal resistance and relation between the internal resistance and the degree of degradation data indicating the degree of battery degradation corresponding to the internal resistance within a given temperature range are stored in memory;
   and the degree of battery degradation is determined from the internal resistance actually measured at a specific temperature using the relation between the internal resistance and the degree of degradation data stored in memory.

3. The method of detecting battery internal resistance as cited in claim 1 or 2 wherein the maximum current for battery charging and discharging is set from battery temperature, detected internal resistance, and battery voltage.

4. The method of detecting battery internal resistance as cited in any one of the claims 1-3 wherein battery voltage and current are detected with a given sampling rate, and battery internal resistance is computed from a plurality of current and voltage measurements made over a preset measurement time interval.

5. The method of detecting battery internal resistance as cited in claim 4 wherein the measurement time interval for computing battery internal resistance is set between 1 sec and 60sec.

6. The method of detecting battery internal resistance as cited in claim 4 wherein if battery temperature varies during the measurement time interval, battery internal resistance computation from that detected data is suspended.

7. The method of detecting battery internal resistance as cited in claim 4 wherein if battery temperature variation during the measurement time interval is less than or equal to 0.5°C to 3°C, battery temperature variation is assumed negligible and battery internal resistance is computed; If battery temperature varies more than 0.5°C to 3°C, battery temperature variation is assumed and internal resistance computation is suspended.

8. The method of detecting battery internal resistance as cited in any one of the claims 1-7 wherein battery voltage and current are detected with a given sampling rate, and battery internal resistance is computed from a plurality of current and voltage measurements made over a preset measurement time interval;
and battery internal resistance is computed using data detected during the measurement time interval that includes battery current, which is higher than a set current.

9. The method of detecting battery internal resistance as cited in claim 8 wherein battery internal resistance is computed from data detected in a measurement time interval when the number of current measurements higher than the set current is greater than a given percentage of the plurality of current values measured during that time interval

10. The method of detecting battery internal resistance as cited in claim 8 wherein the set current during discharging is set proportional to (open circuit battery voltage - the battery low voltage limit) and inversely proportional to battery internal resistance;
and the set current during charging is set proportional to (the battery high voltage limit - open circuit battery voltage) and inversely proportional to battery internal resistance;
where, open circuit battery voltage is the battery voltage with no current flow, the battery low voltage limit is the lowest allowable battery voltage,
and the battery high voltage limit is the highest allowable battery voltage.

11. The method of detecting battery internal resistance as cited in any one of the claims 1-10 wherein battery voltage and current are detected with a given sampling rate, and battery internal resistance is computed from a plurality of current and voltage measurements made over a preset measurement time interval;
and battery internal resistance is computed using data detected during the measurement time interval that includes battery voltage, which is within a predetermined voltage range, and the battery voltage range setting is **characterized by** the battery temperature.

12. The method of detecting battery internal resistance as cited in claim 11 wherein the predetermined voltage range is set between the battery high voltage limit and the high voltage limit minus (0.1 to 0.5) x (the battery high voltage limit - the battery low voltage limit) and between the battery low voltage limit and the low voltage limit plus (0.1 to 0.5) x (the battery high voltage limit - the battery low voltage limit).

13. The method of detecting battery internal resistance as cited in claim 3 wherein the maximum current for battery charging and discharging is set from battery temperature, detected internal resistance, and battery voltage;
when battery internal resistance has not been computed at the present temperature for a given time period and a previously detected (old) battery internal resistance for that temperature is stored in memory, battery internal resistance detected more recently than the old internal resistance, but at a temperature different than the present temperature, is used to estimate the internal resistance at the present temperature from a pre-stored look-up-table or function; and
the maximum battery current is set based on either the old internal resistance or the estimated internal resistance.

14. The method of detecting battery internal resistance as cited in claim 13 wherein the old battery internal resistance stored in memory is updated according to the following equation:

$$\text{internal resistance written to memory} = \text{weight1} \times \text{old internal resistance}$$
$$+ \text{weight2} \times \text{actual measured internal resistance}$$

where, weight1 + weight2 = 1, and weight2 is set from 0.1 to 0.5.

15. The method of detecting battery internal resistance as cited in claim 3 wherein the maximum current for battery charging and discharging is set from battery temperature, detected internal resistance, and battery voltage;
when battery internal resistance has not been computed at the present temperature for a given time period and a previously detected (old) battery internal resistance for that temperature is stored in memory, battery internal resistance detected more recently than the old internal resistance, but at a temperature different than the present temperature, is used to estimate the internal resistance at the present temperature from a pre-stored look-up-table or function; and
when the difference between the estimated internal resistance and the old internal resistance is greater than a specified difference, the maximum battery current can be set based on the estimated internal resistance.

16. The method of detecting battery internal resistance as cited in claim 15 wherein the old battery internal resistance stored in memory is updated according to the following equation:

$$\text{internal resistance written to memory} = \text{weight1} \times \text{old internal resistance}$$

$$+ \text{weight2} \times \text{actual measured internal resistance}$$

where, weight1 + weight2 = 1, and weight2 is set from 0.1 to 0.5.

17. The method of detecting battery internal resistance as cited in any one of the claims 1-16 wherein the battery, in which internal resistance is determined, is a battery installed on-board a vehicle to supply power to a motor that drives the vehicle.

18. The method of detecting battery internal resistance as cited in any one of the claims 1-16 wherein the battery, in which internal resistance is determined, is a battery used for power storage.

FIG. 1

# FIG. 2

POWER SOURCE APPARATUS-SIDE | VEHICLE-SIDE

VOLTAGE DETECTION CIRCUIT — 5

A/D CONVERTER

COMPUTATION CIRCUIT

MEMORY

CURRENT DETECTION CIRCUIT

CONTROL CIRCUIT

BIDIRECTIONAL POWER CONVERTER

M

G

1

1

4

3

2

12

10

9

8

6

7

11

13

# FIG. 3

$V_O$

$R_0$

$I$

$V_L$

## FIG. 4

CHARGING          DISCHARGING

## FIG. 5

VOLTAGE

260V (V_max)

PREDETERMINED VOLTAGE RANGE

235V

220V (V_O)

A

185V

PREDETERMINED VOLTAGE RANGE

160V (V_min)

80A (I_max)    40A (I_C)          60A (I_D)    120A (I_max)

CHARGING CURRENT          DISCHARGING CURRENT

15

# FIG. 6

# FIG. 7

START

n=1 | DETECT BATTERY CURRENT, VOLTAGE, AND TEMPERATURE WITH A GIVEN SAMPLING PERIOD

n=2 | READ INTERNAL RESISTANCE CORRESPONDING TO BATTERY TEMPERATURE FROM MEMORY

n=3 | DOES THE DETECTED DATA SATISFY CONDITIONS FOR COMPUTING INTERNAL RESISTANCE? — NO

YES

n=4 | COMPUTE BATTERY INTERNAL RESISTANCE

n=5 | STORE THE INTERNAL RESISTANCE CORRESPONDING TO BATTERY TEMPERATURE IN MEMORY

n=6 | DETERMINE THE MAXIMUM BATTERY CHARGING AND DISCHARGING CURRENT FROM BATTERY INTERNAL RESISTANCE AND TEMPERATURE, AND SEND IT TO THE VEHICLE-SIDE

n=7 | END

# FIG. 8

START

n=8　READ THE OLD INTERNAL RESISTANCE FOR THE PRESENT BATTERY TEMPERATURE FROM MEMORY

n=9　ESTIMATE INTERNAL RESISTANCE AT THE PRESENT TEMPERATURE FROM AN INTERNAL RESISTANCE RECENTLY DETECTED AT A DIFFERENT TEMPERATURE

n=10　(ESTIMATED INTERNAL RESISTANCE) / (OLD INTERNAL RESISTANCE) > 1.5?　NO

YES

n=11　STORE THE ESTIMATED INTERNAL RESISTANCE IN MEMORY

n=12　END

# FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000012104 A